(19) Europäisches Patentamt
European Patent Office
Office européen des brevets

(11) EP 2 105 466 B1

(12) **EUROPEAN PATENT SPECIFICATION**

(45) Date of publication and mention of the grant of the patent:
**12.06.2013 Bulletin 2013/24**

(51) Int Cl.:
*C08L 83/04* (2006.01) *H01L 23/29* (2006.01)
*H01L 33/00* (2010.01)

(21) Application number: **09250800.1**

(22) Date of filing: **23.03.2009**

(54) **Curable silicone rubber composition and semiconductor devices**

Härtbare Silikon-Kautschuk-Zusammensetzung und Halbleitervorrichtungen

Compositions de caoutchouc en silicone durcissable et dispositifs semi-conducteurs

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **24.03.2008 JP 2008075644**

(43) Date of publication of application:
**30.09.2009 Bulletin 2009/40**

(73) Proprietor: **Shin-Etsu Chemical Co., Ltd.**
**Tokyo (JP)**

(72) Inventor: **Kashiwagi, Tsutomu**
**Annaka-shi,**
**Gunma-ken (JP)**

(74) Representative: **Hallybone, Huw George et al**
**Carpmaels & Ransford**
**One Southampton Row**
**London**
**WC1B 5HA (GB)**

(56) References cited:
**US-A1- 2002 161 140** **US-A1- 2004 178 509**
**US-A1- 2005 244 649** **US-A1- 2006 270 792**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 105 466 B1

Printed by Jouve, 75001 PARIS (FR)

## Description

### BACKGROUND OF THE INVENTION

### 1. Field of the Invention

The present invention relates to an addition-curable silicone rubber composition, and relates particularly to a curable silicone rubber composition that exhibits favorable adhesion to thermoplastics such as PPA (polyphthalamide resins) and liquid crystal polymers (LCP), and to electrode noble metals such as silver and gold. The invention also relates to a semiconductor device encapsulated with a cured product of the curable silicone rubber composition.

### 2. Description of the Prior Art

Silicone rubber compositions form cured products that exhibit excellent properties of weather resistance and heat resistance and the like, as well as superior rubber-like properties such as hardness and elongation, and are therefore used in a wide variety of applications.

In recent years, highly heat-resistant thermoplastics such as PPA (polyphthalamide resins) and LCP (liquid crystal polymers) have been investigated as potential materials for all manner of packages. Further, metals such as Ag, Au, Ni and Pd are used for frames and electrodes. However, securely bonding a silicone rubber to these thermoplastics or metals has proven difficult. Furthermore, the soldering conditions employed within devices formed using these types of materials has now been changed to high-temperature soldering that contains no lead. Accordingly, a problem has arisen in that high-temperature stress, temperature cycling, and storage under high temperature and high humidity tends to result in ready peeling at the interface between the package and the silicone resin. Furthermore, another problem also occurs in that the heat generated from LEDs (light emitting diodes) causes degradation and hardening of the silicone resin, leading to cracking of the resin (for example, see Patent Document 1).

In most addition-curable silicone rubber compositions, any of a variety of silane coupling agents are added to improve the adhesion, but coupling agents that include a large amount of epoxy groups have a high refractive index, resulting in a loss of transparency for the composition. Furthermore, vigorous reaction can result in discoloration or clouding of the composition, meaning such compositions are unsuited to optical applications and the like. An addition-curable silicone rubber composition disclosed in Patent Document 2 exhibits superior adhesion to metals such as Ag, Au, Ni and Pd, but in terms of its anti-discoloration and light resistance properties, the composition is unsatisfactory for optical applications.

[Patent Document 1] JP 2003-174059A
[Patent Document 2] US2006/0270792A1

### SUMMARY OF THE INVENTION

The present invention has been developed in light of the above circumstances, and has an object of providing a curable silicone rubber composition which generates satisfactory adhesive strength to all manner of package materials composed of thermoplastics such as PPA (polyphthalamides) and LCP (liquid crystal polymers), which are inherently difficult to bond, and to electrodes composed of metals such as Ag, Au, Ni and Pd, and which yields a cured product that has favorable transparency. Another object of the present invention is to provide a semiconductor device that has been encapsulated with a cured product of such a composition.

As a result of intensive investigation aimed at achieving the above objects, the inventors of the present invention discovered that a curable silicone rubber composition for which the difference between the refractive indices of certain predetermined organopolysiloxane components was not more than a predetermined value generated good adhesive strength even to substrates that are inherently difficult to bond, including all manner of package materials composed of thermoplastics such as PPA and LCP, and electrodes and the like composed of metals such as Ag, Au, Ni and Pd, and also formed a cured product having favorable transparency. The inventors also discovered that a semiconductor device encapsulated with such a cured product displayed excellent reliability, and based on these findings, they were able to complete the present invention.

In other words, the present invention provides a curable silicone rubber composition, comprising:

(A) a linear organopolysiloxane (A-1) represented by a general formula (1) shown below, having a viscosity at 25°C within a range from 10 to 1,000,000 mpa·s,

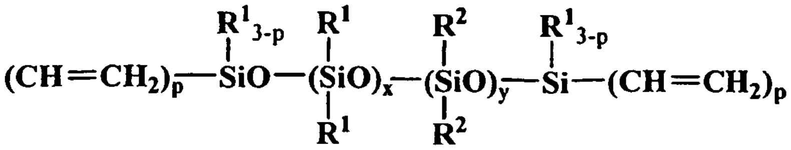

(1)

wherein each $R^1$ represents, independently, an unsubstituted or substituted monovalent hydrocarbon group, each $R^2$ represents, independently, an unsubstituted or substituted monovalent hydrocarbon group having no aliphatic unsaturated bonds, x and y each represents either 0 or a positive integer, provided that x+y is a number that yields a viscosity at 25°C for the organopolysiloxane of 10 to 1,000,000 mPa·s, and p is an integer from 1 to 3, or

a mixture of the organopolysiloxane (A-1) and a resin-structure organopolysiloxane (A-2) composed of $SiO_2$ units, $R^3_kP^4_pSiO_{0.5}$ units and $R^3_qR^4_rSiO_{0.5}$ units, wherein $R^3$ represents a vinyl group or allyl group, $R^4$ represents a monovalent hydrocarbon group containing no aliphatic unsaturated bonds, k is 2 or 3 and p is 0 or 1, provided that k+p = 3, q is 0 or 1 and r is 2 or 3, provided that q+r = 3,

(B) an organohydrogenpolysiloxane having two or more SiH groups within each molecule,

(C) a metal-based condensation reaction catalyst,

(D) a platinum group metal-based addition reaction catalyst, and

(E) an organopolysiloxane-based adhesion-imparting agent containing at least two types of functional groups selected from the group consisting of alkenyl groups, alkoxy groups and epoxy group, wherein

among refractive indices of component (A), a mixture of component (A) and component (B), and component (E), a difference between a maximum refractive index and a minimum refractive index is not more than 0.03.

The curable silicone rubber composition of the present invention generates effective adhesion to substrates such as Ag and PPA that have proven extremely difficult to bond until now, and a semiconductor device encapsulated with a cured product of this composition is capable of withstanding severe reliability testing.

BRIEF DESCRIPTION OF THE DRAWINGS

FIG. 1 is a schematic perspective view describing a method of measuring the shear adhesive strength in examples of the present invention.

FIG. 2 is a schematic cross-sectional view describing a package shape used in a high-humidity reflow test in examples of the present invention.

DETAILED DESCRIPTION OF THE PREFERRED EMBODIMENTS

[(A-1) Linear Organopolysiloxane]

The component (A-1) has a viscosity at 25°C that is typically within a range from 10 to 1,000,000 mPa·s, and preferably from 100 to 100,000 mPa·s. This viscosity can be measured using a rotational viscometer. This linear organopolysiloxane is represented by a general formula (1) shown below, and includes vinyl groups on the silicon atoms at both molecular chain terminals. The organopolysiloxane may include some branched structures (trifunctional siloxane units) within the molecular chain, in an amount that does not impair the effects of the present invention.

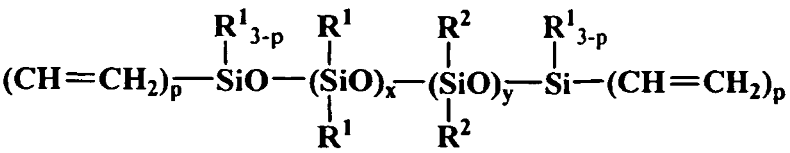

(1)

(wherein each $R^1$ represents, independently, an unsubstituted or substituted monovalent hydrocarbon group, each $R^2$ represents, independently, an unsubstituted or substituted monovalent hydrocarbon group having no aliphatic unsaturated bonds, x and y each represents either 0 or a positive integer, provided that x+y is a number that yields a viscosity

at 25°C for the organopolysiloxane of 10 to 1,000,000 mPa·s, and p is an integer from 1 to 3)

In the general formula (1), $R^1$ is preferably a monovalent hydrocarbon group of 1 to 10 carbon atoms, and particularly 1 to 6 carbon atoms, and specific examples include alkyl groups such as a methyl group, ethyl group, propyl group, isopropyl group, butyl group, isobutyl group, tert-butyl group, pentyl group, neopentyl group, hexyl group, cyclohexyl group, octyl group, nonyl group or decyl group; aryl groups such as a phenyl group, tolyl group, xylyl group or naphthyl group; aralkyl groups such as a benzyl group, phenylethyl group or phenylpropyl group; alkenyl groups such as a vinyl group, allyl group, propenyl group, isopropenyl group, butenyl group, hexenyl group, cyclohexenyl group or octenyl group; and groups in which some or all of the hydrogen atoms within one of the above hydrocarbon groups have been replaced with a halogen atom such as a fluorine atom, bromine atom or chlorine atom, or a cyano group or the like, including halogenated alkyl groups such as a chloromethyl group, chloropropyl group, bromoethyl group or trifluoropropyl group, and a cyanoethyl group. $R^1$ is preferably a methyl group, phenyl group or vinyl group.

Furthermore, $R^2$ is also preferably a monovalent hydrocarbon group of 1 to 10 carbon atoms, and particularly 1 to 6 carbon atoms, and specific examples of $R^2$ include the same groups as those listed above for $R^1$, but excluding those groups containing an aliphatic unsaturated bond such as the alkenyl groups. $R^2$ is preferably a methyl group or a phenyl group.

Examples of the component (A-1) include the compounds shown below.

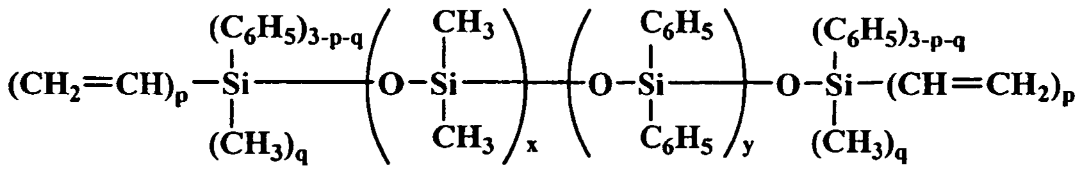

In this formula, p represents 1 or 2, q is an integer of 0 to 3, and x and y are both integers of 0 or greater that satisfy $0 < x+y \leq 2{,}000$, preferably $5 \leq x+y \leq 1{,}500$, and still more preferably $10 \leq x+y \leq 1{,}000$, and also satisfy $0 \leq y/(x+y) \leq 0.5$, and preferably $0 \leq y/(x+y) \leq 0.35$. Specific examples of this component (A-1) include the compounds shown below.

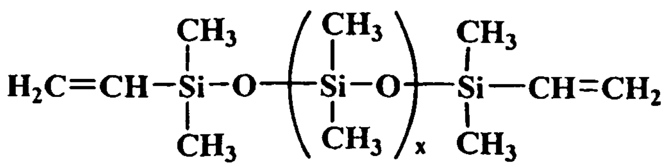

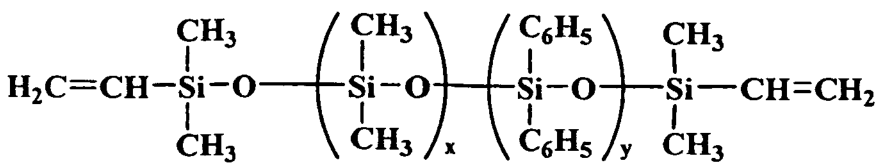

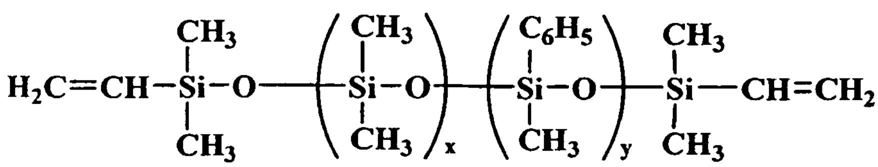

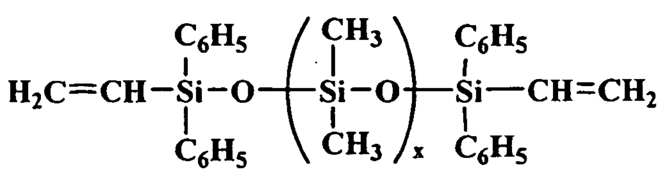

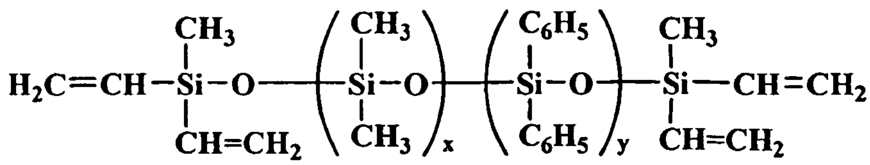

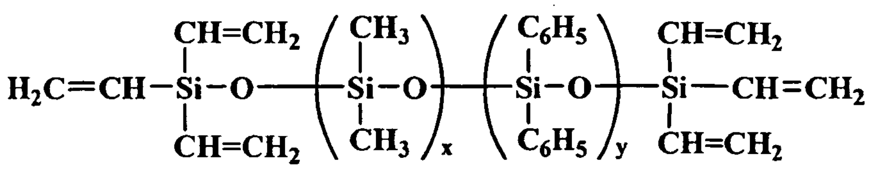

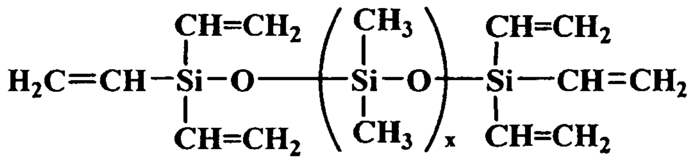

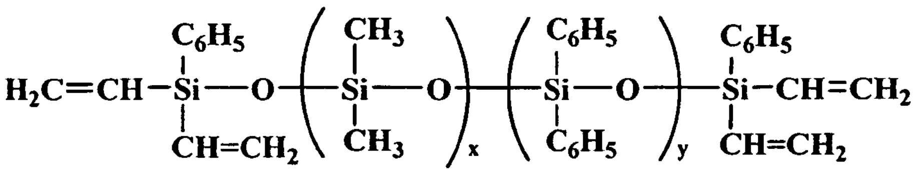

(wherein, x and y are as defined above)

[(A-2) Resin-structure Organopolysiloxane]

Furthermore, in the present invention, a resin-structure organopolysiloxane may be used in combination with the organopolysiloxane described above. This resin-structure (namely, three dimensional network-type structure) organopolysiloxane is composed of $SiO_2$ units, $R^3_kR^4_pSiO_{0.5}$ units and $R^3_qR^4_rSiO_{0.5}$ units (wherein $R^3$ represents a vinyl group or allyl group, $R^4$ represents an unsubstituted or substituted monovalent hydrocarbon group containing no aliphatic unsaturated bonds, k is 2 or 3 and p is 0 or 1, provided that k+p = 3, and q is 0 or 1 and r is 2 or 3, provided that q+r = 3). Examples of the monovalent hydrocarbon group $R^4$ include the same hydrocarbon groups of 1 to 10 carbon atoms, and preferably 1 to 6 carbon atoms, as those listed above for $R^2$.

In this resin-structure organopolysiloxane, if the $SiO_2$ units are termed "a units", the $R^3_kR^4_pSiO_{0.5}$ units are termed "b units", and the $R^3_qR^4_rSiO_{0.5}$ units are termed "c units", then the respective molar proportions of these units preferably satisfy the equations shown below.
(b+c)/a = 0.3 to 2, and particularly 0.7 to 1.5
c/a = 0.1 to 2, and particularly 0.2 to 1.5

Furthermore, this organopolysiloxane preferably has a weight average molecular weight, measured by GPC and referenced against polystyrene standards, that falls within a range from 500 to 10,000.

In addition to the a units, b units and c units mentioned above, the resin-structure organopolysiloxane may also include small amounts of bifunctional siloxane units and trifunctional siloxane units (namely, organosilsesquioxane units), provided inclusion of these units does not impair the effects of the present invention.

This type of resin-structure organopolysiloxane can be synthesized easily, by combining the compounds that act as the source materials for each of the units, in amounts that yield the molar proportions described above, and then conducting a cohydrolysis in the presence of an acid or the like.

Examples of the source material for the a units include sodium silicate, alkyl silicates, polyalkyl silicates, and

silicon tetrachloride.

Examples of the source material for the b units include the compounds shown below.

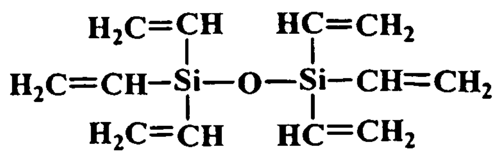

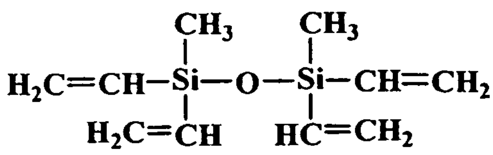

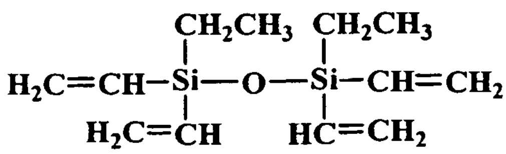

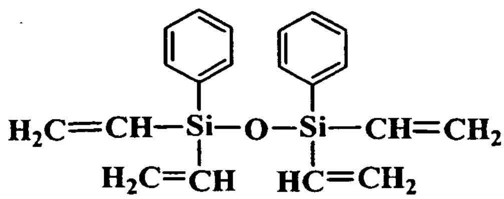

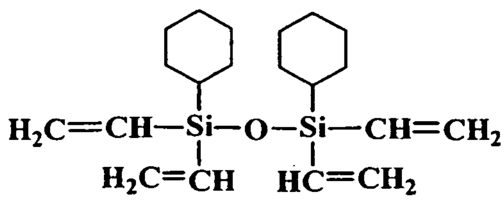

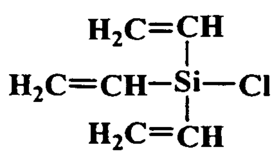

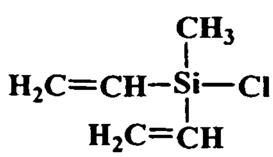

Moreover, examples of the source material for the c units include the compounds shown below.

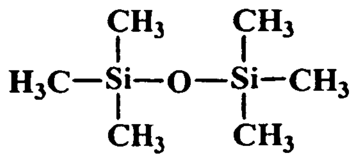

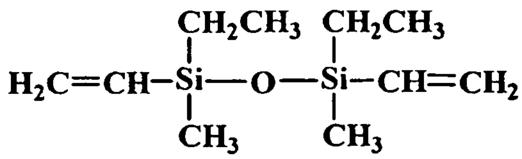

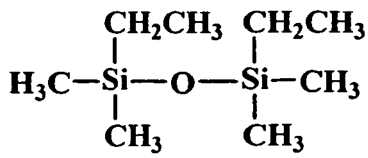

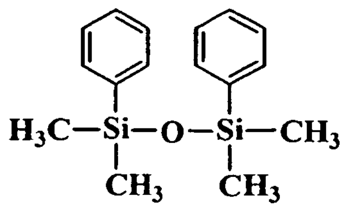

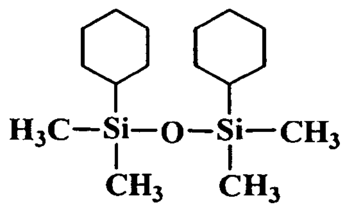

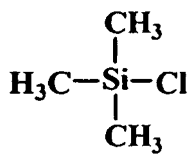

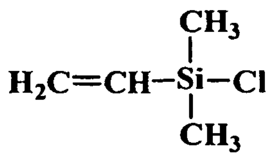

The above resin-structure organopolysiloxane (A-2) has the effects of improving the physical strength and of reducing surface tack of the cured product. The component (A) preferably comprises 20 to 70% by mass, and more preferably 30 to 60% by mass, of the component (A-2). If the amount of the resin-structure organopolysiloxane is too high, then the viscosity of the composition may increase dramatically, or the cured product may become prone to cracking.

[(B) Organohydrogenpolysiloxane]

The organohydrogenpolysiloxane (B) functions as a cross-linking agent, wherein the cured product is formed as a result of an addition reaction between the SiH groups within this component and the alkenyl groups within component (A). This organohydrogenpolysiloxane contains two or more, and preferably three or more, SiH groups within each molecule. Examples of the organohydrogenpolysiloxane include compounds represented by an average composition formula (2) shown below:

$$H_a(R^5)_bSiO_{(4-a-b)/2} \qquad (2)$$

(wherein, $R^5$ represents identical or different, unsubstituted or substituted monovalent hydrocarbon groups that contain no aliphatic unsaturated bonds, and a and b are numbers that satisfy the formulas: $0.001 \leq a < 2$, $0.7 \leq b \leq 2$, and $0.8 \leq a+b \leq 3$), which contain at least two, and preferably 3 or more, SiH groups within each molecule.

In the above formula (2), $R^5$ is preferably a monovalent hydrocarbon group of 1 to 10 carbon atoms, and particularly from 1 to 7 carbon atoms, and specific examples include those groups listed above in relation to the substituent group $R^2$ within the aforementioned general formula (1), including lower alkyl groups such as a methyl group and aryl groups such as a phenyl group. Furthermore, a and b are preferably numbers that satisfy the formulas: $0.05 \leq a \leq 1$, $0.8 \leq b \leq 2$, and $1 \leq a+b \leq 2.7$. There are no particular restrictions on the positions of the hydrogen atoms bonded to silicon atoms, which may be at the molecular terminals or at non-terminal positions within the molecular chain.

Specific examples of the above organohydrogenpolysiloxane include tris(dimethylhydrogensiloxy)methylsilane, tris(dimethylhydrogensiloxy)phenylsilane, 1,1,3,3-tetramethyldisiloxane, 1,3,5,7-tetramethylcyclotetrasiloxane, methylhydrogenpolysiloxane with both terminals blocked with trimethylsiloxy groups, copolymers of dimethylsiloxane and methylhydrogensiloxane with both terminals blocked with trimethylsiloxy groups, dimethylpolysiloxane with both terminals blocked with dimethylhydrogensiloxy groups, copolymers of dimethylsiloxane and methylhydrogensiloxane with both terminals blocked with dimethylhydrogensiloxy groups, copolymers of methylhydrogensiloxane and diphenylsiloxane with both terminals blocked with trimethylsiloxy groups, copolymers of methylhydrogensiloxane, diphenylsiloxane and dimethylsiloxane with both terminals blocked with trimethylsiloxy groups, copolymers composed of $(CH_3)_2HSiO_{1/2}$ units and $SiO_{4/2}$ units, and copolymers composed of $(CH_3)_2HSiO_{1/2}$ units, $SiO_{4/2}$ units, and $(C_6H_5)SiO_{3/2}$ units.

Examples of the organohydrogenpolysiloxane (B) include the linear compounds shown below.

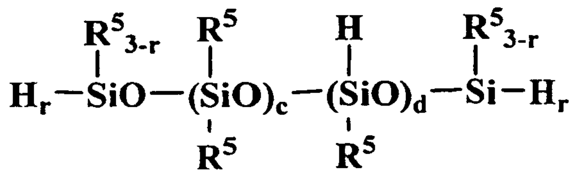

In this formula, $R^5$ is as defined above, and r represents 0 or 1. c and d are integers that satisfy $0 \leq c \leq 500$ and preferably $0 \leq c \leq 200$, and $0 \leq d \leq 500$ and $0 \leq d \leq 200$ respectively, provided that when r is 0, d is an integer of 2 or greater. (c+d) is an integer that satisfies $1 \leq c+d \leq 1{,}000$ and preferably $1 \leq c+d \leq 300$. Specific examples of the organohydrogenpolysiloxane (B) include the compounds listed below.

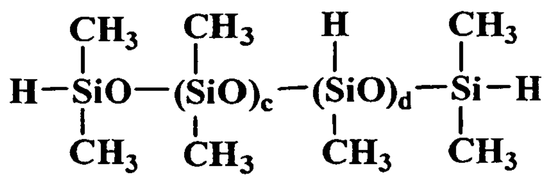

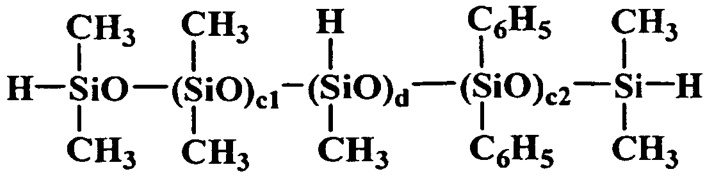

(wherein c1+c2 = c)

Further examples of the organohydrogenpolysiloxane (B) include the branched compounds shown below.

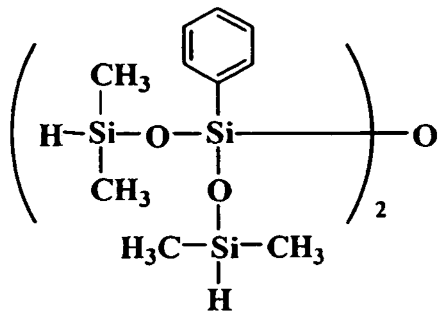

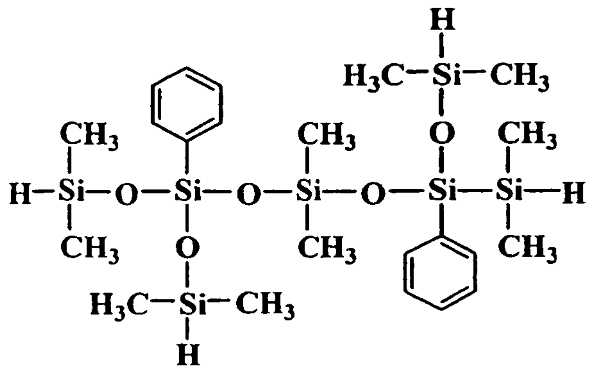

The molecular structure of the organohydrogenpolysiloxane of component (B) may be a linear, cyclic, branched, or three dimensional network-type structure. The number of silicon atoms within a single molecule (or the polymerization degree) is typically within a range from 3 to 1,000, and preferably from approximately 3 to 300.

This type of organohydrogenpolysiloxane can normally be obtained either by hydrolysis of a chlorosilane such as $R^SSiHCl_2$, $(R^5)_3SiCl$, $(R^5)_2SiCl_2$ or $(R^5)_2SiHCl$ (wherein, $R^5$ is as defined above), or by equilibration of the siloxane obtained upon hydrolysis.

The blend amount of this organohydrogenpolysiloxane must be effective in curing the component (A), and is typically used in an amount that provides a molar ratio of 0.7 to 4.0 mols, preferably 1.0 to 3.0 mols, and still more preferably 1.2 to 2.0 mols, of SiH groups per 1 mol of all the alkenyl groups (such as vinyl groups) within the component (A). If the molar ratio is less than the lower limit of the above range, then obtaining a cured product may become difficult, whereas if the molar ratio exceeds the upper limit, large amounts of unreacted SiH groups tends to remain within the cured product, which can cause changes in the physical properties of the rubber over time.

[(C) Metal-based Condensation Catalyst]

The metal-based condensation catalyst (C) causes reaction of the functional groups such as the epoxy groups or alkoxy groups within the adhesion-imparting agent (E). The metal within the catalyst is preferably aluminum or zirconium. Under heat or the like, the condensation catalyst may cause cleavage of the silicone, and therefore depending on the conditions under which the composition is to be stored and used, a zirconium-based catalyst may be more

preferable. Examples of aluminum-based catalysts include aluminum trihydroxide, aluminum alcoholates, aluminum acylates, aluminum acylate salts, aluminosiloxy compounds, and aluminum metal chelate compounds, and of these, aluminum chelate compounds are preferred. Specific examples of catalysts formed from this type of aluminum chelate compound include the commercially available products ACS and Chelope EB-2 (manufactured by Hope Chemical Co., Ltd.).

Examples of zirconium catalysts include zirconium alkoxides such as zirconium tetra-normal-propoxide and zirconium tetra-normal-butoxide, zirconium chelates such as zirconium tributoxy monoacetonate, zirconium tributoxy monoacetylacetonate and zirconium tetraacetylacetonate, and zirconium acylates such as zirconium tributoxy monostearate and zirconium acetate.

The blend amount of the metal-based condensation catalyst is preferably within a range from 0.005 to 10 parts by mass, and more preferably from 0.05 to 2 parts by mass, relative to 100 parts by mass of a combination of the components (A) and (E). If this blend amount is less than the lower limit of this range, then a satisfactory effect may not be obtained, whereas a blend amount that exceeds the upper limit may have an adverse effect on the curing properties (such as the hardness and external appearance) of the resin.

[(D) Platinum Group Metal-based Addition Reaction Catalyst]

The platinum group metal-based catalyst (D) is added to promote the addition curing reaction within the composition of the present invention. Examples of the component (D) include platinum-based, palladium-based, and rhodium-based catalysts, although from the viewpoint of cost, platinum-based catalysts such as platinum, platinum black and platinic chlorides are preferred, including $H_2PtCl_6 \cdot mH_2O$, $K_2PtCl_6$, $KHPtCl_6 \cdot mH_2O$, $K_2PtCl_4$, $K_2PtCl_4 \cdot mH_2O$, $PtO_2 \cdot mH_2O$, (wherein m represents a positive integer), as well as complexes of these compounds with hydrocarbons such as olefins, alcohols, or vinyl group-containing organopolysiloxanes. Either a single catalyst or a combination of two or more different catalysts may be used.

The blend amount of this catalyst component need only be a so-called effective catalytic amount, and a typical amount, calculated as an equivalent mass of the platinum group metal relative to the mass of the component (A), is within a range from 0.1 to 1,000 ppm, and preferably from 0.5 to 200 ppm.

[(E) Adhesion-Imparting Agent]

The adhesion-imparting agent (E) is an organopolysiloxane containing at least two types of functional groups selected from the group consisting of alkenyl groups, alkoxy groups and epoxy group. Examples of the alkenyl groups include a silicon atom-bonded vinyl group or allyl group. Examples of the alkoxy groups include a methoxy group, ethoxy group, or a trimethoxysilyl group bonded to a silicon atom via a silethylene group. Examples of the epoxy group-containing groups include a glycidoxypropyl group or a 3,4-epoxycyclohexylethyl group. The organopolysiloxane is typically a linear or cyclic organopolysiloxane containing 4 to 100 silicon atoms, preferably 4 to 50 silicon atoms, and still more preferably approximately 4 to 20 silicon atoms, and having a polystyrene-referenced weight average molecular weight of 150 to 4,000.

Examples of the adhesion-imparting agent (E) include the compounds represented by the formulas shown below.

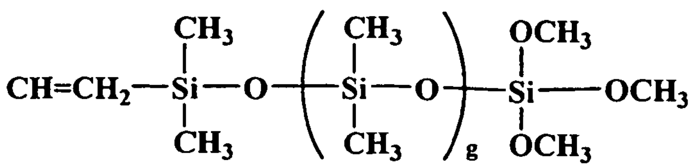

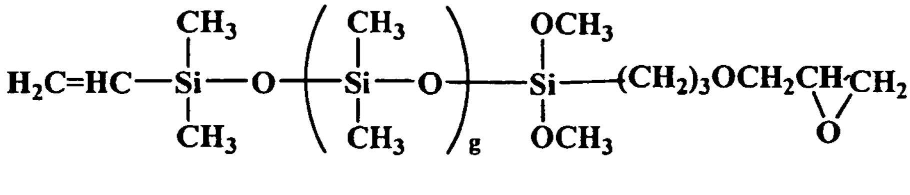

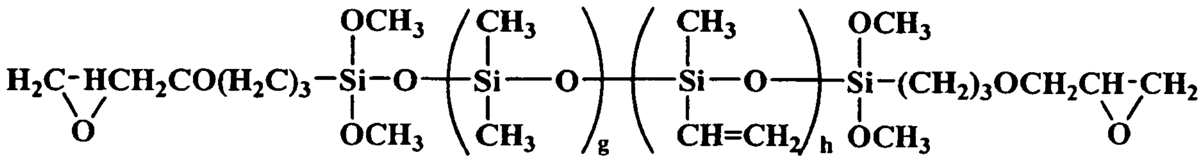

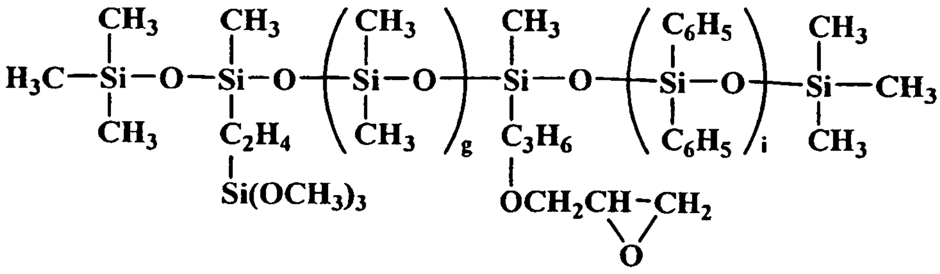

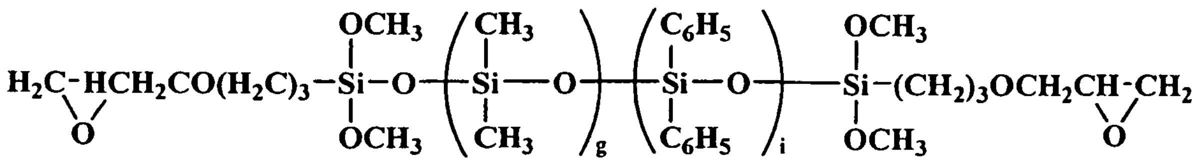

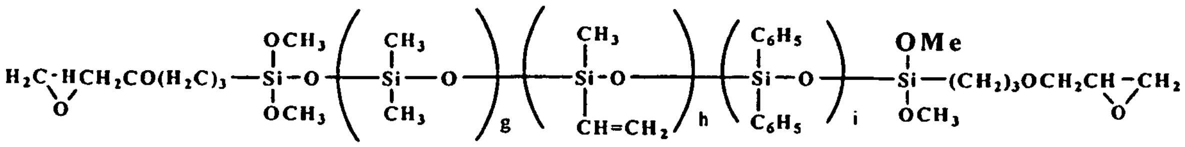

(wherein g, h and i are positive integers for which g+h+i is within a range from 1 to 50 and preferably from 4 to 20)

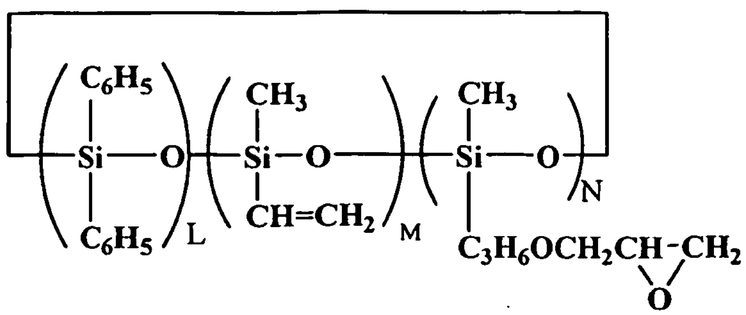

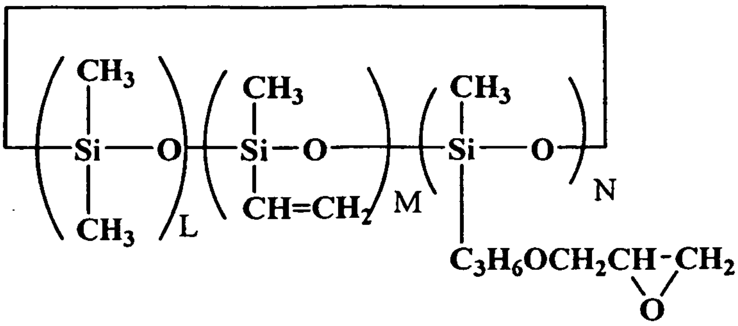

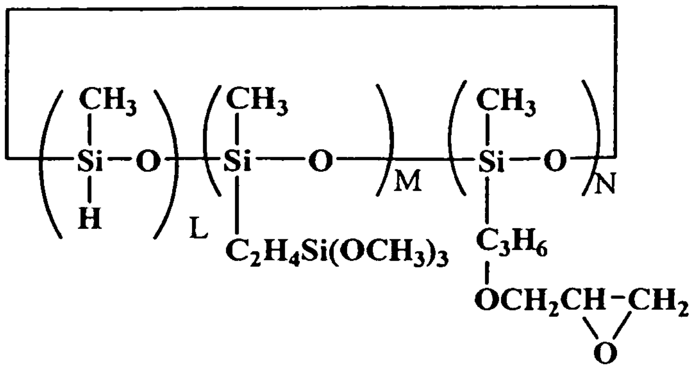

(wherein L, M and N are positive integers for which L+M+N is within a range from 3 to 8 and preferably from 4 to 6)

The blend amount of the adhesion-imparting agent (E) is preferably within a range from 0.01 to 10 parts by mass, more preferably from 0.01 to 5 parts by mass, and most preferably from 0.1 to 3 parts by mass, per 100 parts by mass of the component (A). If the blend amount of the component (E) is less than the lower limit of this range, then the adhesion of the composition to substrates tends to deteriorate, whereas a blend amount that is too large may have an adverse effect on the hardness and surface tack of the cured product.

In the present invention, the difference between the maximum refractive index and the minimum refractive index among the refractive indices of the component (A), a mixture of the component (A) and the component (B), and the component (E) is typically not more than 0.03, preferably not more than 0.02, and still more preferably 0.015 or less. Here, the term "refractive index" refers to the refractive index $n_D$ at sodium-D light at 25°C, and can be measured using an Abbe refractometer. By ensuring that this difference between the refractive indices is not more than the above value, the compatibility of the components can be improved, and the transparency of the resulting cured product increases, making the composition ideal for encapsulating light emitting elements.

Examples of preferred combinations of the component (A), the component (B) and the component (E) for satisfying the above refractive index condition include combinations in which neither the component (A) nor the component (E) contain any aromatic groups, and combinations in which at least one of the component (A), the component (B) and the component (E) contains aromatic groups, and in which the maximum and minimum mol% values for aromatic groups within these components satisfies the formula shown below.

$[(\text{maximum value - minimum value})/\text{maximum value}] \leq 0.3$

In the latter case, phenyl groups are preferred as the aromatic groups, and the mol% value refers to the ratio, expressed as a percentage, of the number of mols of aromatic groups relative to the total number of mols of silicon atom-bonded substituents.

[Other Additives]

In addition to the components (A) to (E) described above, if required, the composition of the present invention may also include a variety of conventional additives. For example, reinforcing inorganic fillers such as fumed silica and fumed titanium dioxide, and non-reinforcing inorganic fillers such as calcium carbonate, calcium silicate, titanium dioxide, ferric oxide, carbon black and zinc oxide may be added to the composition in amounts that do not impair the effects of the present invention, and preferably in amounts of 1 to 50% by mass relative to the total mass of the composition.

A silicone rubber composition of the present invention is prepared by mixing each of the above components uniformly together, although in order to ensure curing does not proceed, the composition is usually stored as two separate liquids, and these two liquids are then mixed together and cured at the time of use. Needless to say, a one-pot composition containing a small amount of an added curing inhibitor such as an acetylene alcohol is also possible. Further, in the case of a two-pot composition, including the component (B) and the component (C) in the same liquid must be avoided in order to prevent the possibility of dehydrogenation reactions.

The viscosity of the thus obtained silicone rubber composition at 25°C, measured using a rotational viscometer, is typically within a range from 100 to 10,000,000 mPa·s, and is preferably from approximately 300 to 500,000 mPa·s.

If required, the silicone rubber composition of the present invention can be cured immediately by heating, and because the composition has a high degree of transparency and bonds strongly to package materials such as LCPs and metal substrates, it can be used widely as a material for coating or encapsulating semiconductor chips such as LED, photodiodes, CCD and CMOS.

Although there are no particular restrictions on the curing conditions used for the composition of the present invention, curing is typically conducted at 40 to 250°C, and preferably at 60 to 200°C, for a period of 5 minutes to 10 hours, and preferably 30 minutes to 6 hours.

In order to coat or encapsulate a semiconductor chip mounted on a support, the composition of the present invention is coated onto the semiconductor chip, subsequently molded into the desired shape, and then cured by heating.

EXAMPLES

The present invention is described in further detail below using a series of examples and comparative examples, although the present invention is in no way limited by these examples. In the following examples, the units "parts" refer to "parts by mass", Me represents a methyl group, Ph represents a phenyl group, and Vi represents a vinyl group. Refractive index values refer to the refractive index $n_D$ relative to sodium-D light measured at 25°C using an Abbe refractometer.

[Example 1]

50 parts of a polysiloxane (VF) represented by a formula (i) shown below:

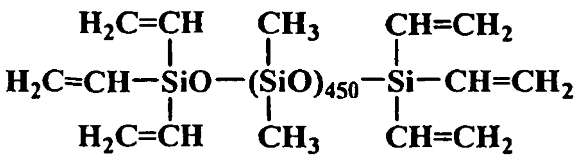

( i )

was mixed with 50 parts of a resin-structure vinylmethylsiloxane (VMQ) composed of 50 mol% of $SiO_2$ units, 42.5 mol% of $(CH_3)_3SiO_{0.5}$ units and 7.5 mol% of $Vi_3SiO_{0.5}$ units. The refractive index of the resulting mixture was 1.41. This mixture was then mixed with an organohydrogenpolysiloxane represented by formula (ii) shown below,

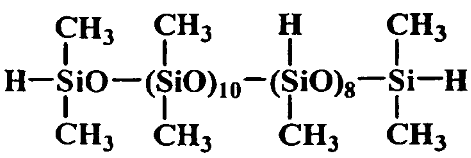

( ii )

which was added in sufficient amount to provide 1.5 mols of SiH groups per mol of vinyl groups within the combination of the VF and VMQ components. To the resulting mixture (refractive index: 1.41) were added and mixed 0.05 parts of a solution of octyl alcohol-modified chloroplatinic acid (platinum concentration: 2% by mass), 0.1 parts of an aluminum chelate catalyst ACS (a product name, manufactured by Hope Chemical Co., Ltd.)., and 1 part of an adhesion-imparting agent (refractive index: 1.42) represented by a formula shown below:

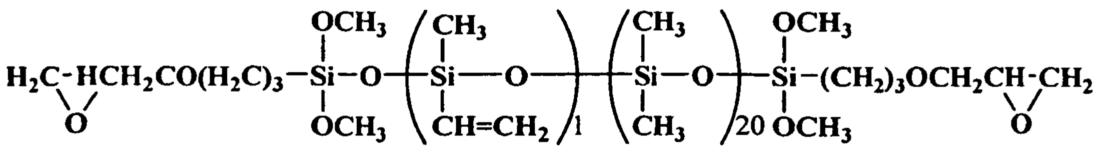

thus yielding a silicone rubber composition.

[Example 2]

With the exception of replacing the adhesion-imparting agent used in example 1 with an adhesion-imparting agent having a refractive index of 1.43, represented by a formula shown below:

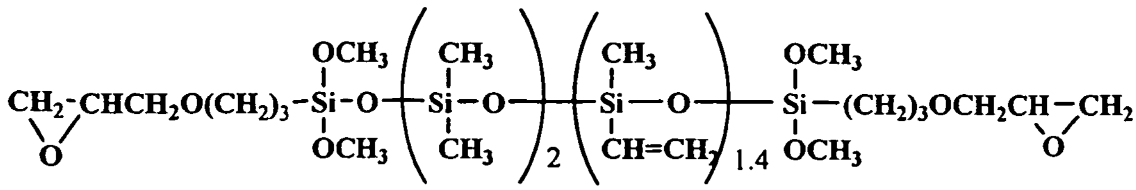

a silicone rubber composition was prepared in the same manner as example 1.

[Example 3]

A mixture (refractive index: 1.51) was prepared by mixing 100 parts of a vinylsiloxane (refractive index: 1.51) represented by a formula shown below, and 8 parts of a hydrogensiloxane represented by a formula shown below.

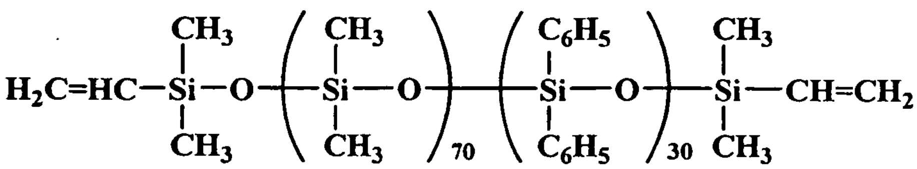

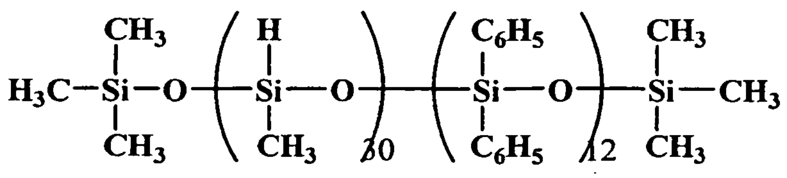

To 100 parts of this mixture were added 0.05 parts of a solution of octyl alcohol-modified chloroplatinic acid (platinum concentration: 2% by mass), 0.1 parts of an aluminum chelate catalyst ACS (a product name, manufactured by Hope Chemical Co., Ltd.)., and 1 part of an adhesion-imparting agent (refractive index: 1.50) represented by a formula shown below:

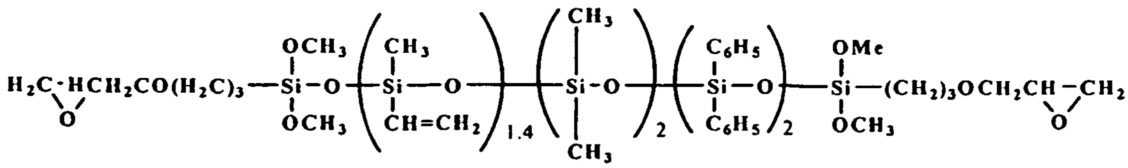

thus forming a silicone rubber composition in the same manner as example 1.

[Example 4]

50 parts of a polysiloxane (VF) represented by a formula (i) shown below:

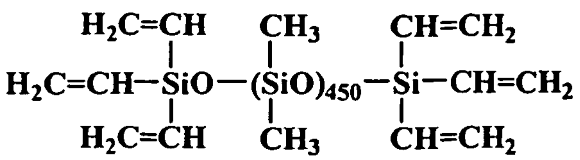

(i)

was mixed with 50 parts of a resin-structure vinylmethylsiloxane (VMQ) composed of 50 mol% of $SiO_2$ units, 42.5 mol% of$(CH_3)_3SiO_{0.5}$ units and 7.5 mol% of $Vi_3SiO_{0.5}$ units. The refractive index of the resulting mixture was 1.41. This mixture was then mixed with an organohydrogenpolysiloxane represented by formula (ii) shown below,

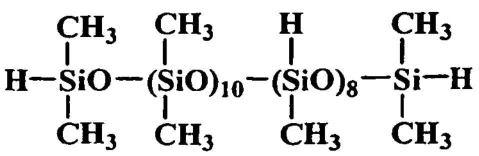

(ii)

which was added in sufficient amount to provide 1.5 mols of SiH groups per mol of vinyl groups within the combination of the VF and VMQ components. To the resulting mixture (refractive index: 1.41) were added and mixed 0.05 parts of a solution of octyl alcohol-modified chloroplatinic acid (platinum concentration: 2% by mass), 0.1 parts of a zirconium alkoxide (Orgatix ZA60 (a product name), manufactured by Matsumoto Trading Co., Ltd.), and 1 part of an adhesion-imparting agent (refractive index: 1.42) represented by a formula shown below:

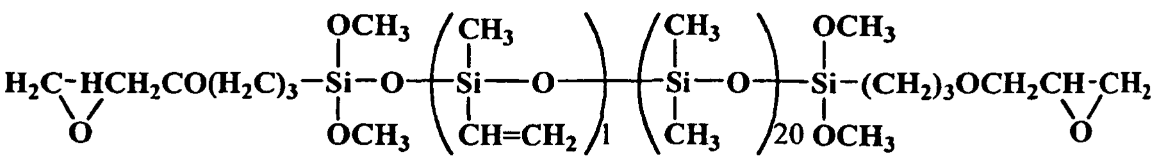

thus yielding a silicone rubber composition.

[Comparative Example 1]

With the exception of not adding the aluminum metal chelate catalyst ACS, a silicone rubber composition was prepared in the same manner as example 1.

[Comparative Example 2]

With the exception of not adding the aluminum metal chelate catalyst ACS, a silicone rubber composition was

prepared in the same manner as example 3.

[Comparative Example 3]

With the exception of replacing the adhesion-imparting agent used in example 1 with the adhesion-imparting agent used in example 3, a silicone rubber composition was prepared in the same manner as example 1.

[Evaluation Methods]

Each of the compositions was evaluated using the methods described below. The results are shown in Tables 1 to 3.

<External appearance, light transmittance, tensile strength, hardness, elongation>

The composition was heat-molded for 4 hours at 150°C to form a cured product of thickness 1 mm, and the external appearance of the cured product was evaluated by visual inspection. Further, the light transmittance (450 nm) was measured using an absorption meter. Furthermore, the tensile strength, hardness (measured using a type-A spring tester) and elongation were measured in accordance with the methods prescribed in JIS K 6301.

<PPA shear adhesive strength>

As shown in FIG. 1, two substrate fragments 1 and 2 formed from PPA (polyphthalamide resin) strips of width 25 mm were bonded together by overlapping the ends of the two fragments to a length of 10 mm with a 1 mm thick composition layer 3 provided between the overlapped ends, and then curing the composition layer 3 by heat-curing for 4 hours at 150°C. The resulting test piece was left to stand at room temperature for at least 12 hours, and the tensile shear adhesive strength was then measured by using a pull tester to pull the two ends 4 and 5 of the test piece in the directions shown by the arrows.

<Cohesive failure rate>

The fractured surface of the test piece following measurement of the shear adhesive strength was evaluated by determining the ratio of the surface area across which cohesive failure occurred (that is, those areas where the PPA and the silicone rubber (the cured product of the composition layer 3) did not undergo interface separation, but rather the silicone rubber itself fractured) relative to the total surface area of the fractured surface, and this ratio (as a percentage) was recorded as the cohesive failure rate.

<Reflow resistance>

The silicone rubber composition was injected into the dummy package shown in FIG. 2 (product name: Amodel, manufactured by Solvay S.A.) and was then cured at 150°C for 4 hours, and a high-humidity reflow test was then conducted in accordance with MSL level 2. In FIG. 2, a semiconductor chip 9 is mounted on a silver-plated pad of a lead frame 8 positioned inside the recess of a package 6 formed from PPA (polyphthalamide resin), and this semiconductor chip 9 is connected to an electrode via a wire 10. The silicone rubber composition 7 was injected into the recess and cured, thus encapsulating the semiconductor chip 9 and the wire 10. The resulting device was placed inside a thermostatic chamber at 85°C and 85% RH, a 20 mA current was supplied to the chip 9 for a predetermined period of time, and the composition 7 was inspected for peeling. Furthermore, a high-humidity reflow test was conducted in accordance with the MSL test methods, by allowing the device to stand for 16 hours in an atmosphere at 60°C and 90% RH to ensure thorough moisture absorption, passing the device through an IR reflow oven at a maximum temperature of 260°C, and then returning the device to 85°C and 85% RH and visually inspecting the device for the presence of peeling or cracking for a period up to 1,000 hours. The results are shown in Table 3. In Table 3, the numerical values represent the proportion (%) of devices in which a fault was detected for a sample size of n=20.

[Table 1]

| | Example 1 | Example 2 | Example 3 | Example 4 |
|---|---|---|---|---|
| SiH/SiVi | 1.5 | 1.5 | 1.5 | 1.5 |

(continued)

| | Example 1 | Example 2 | Example 3 | Example 4 |
|---|---|---|---|---|
| External appearance | colorless and transparent | colorless and transparent | colorless and transparent | colorless and transparent |
| Light transmittance % | 95 | 98 | 98 | 95 |
| Refractive index $n_D$ of (A)+(B) | 1.41 | 1.41 | 1.51 | 1.41 |
| Curing conditions | 150°C / 4 hr | 150°C / 4 hr | 150°C / 4 hr | 150°C / 4 hr |
| Hardness (type A) | 70 | 71 | 70 | 70 |
| Elongation (%) | 30 | 30 | 30 | 30 |
| Tensile strength (MPa) | 7 | 7 | 7 | 7 |
| PPA shear adhesive strength (MPa) | 5 | 4 | 5 | 5 |
| Cohesive failure rate (%) | 80 | 80 | 90 | 80 |

[Table 2]

| | Comparative example 1 | Comparative example 2 | Comparative example 3 |
|---|---|---|---|
| SiH/SiVi | 1.5 | 1.5 | 1.5 |
| External appearance | colorless and transparent | colorless and transparent | cloudy |
| Curing conditions | 150°C / 4 hr | 150°C / 4 hr | 150°C / 4 hr |
| Hardness (type A) | 70 | 72 | 72 |
| Elongation (%) | 30 | 30 | 30 |
| Tensile strength (MPa) | 6 | 7 | 7 |
| PPA shear adhesive strength (MPa) | 2 | 2 | 2 |
| Cohesive failure rate (%) | 50 | 30 | 30 |

[Table 3]

| | Example 1 | Example 2 | Example 3 | Example 4 | Comparative example 1 | Comparative example 2 | Comparative example 3 |
|---|---|---|---|---|---|---|---|
| Immediately after curing | 0 | 0 | 0 | 0 | 0 | 0 | 0 |
| 120 hr | 0 | 0 | 0 | 0 | 10 | 5 | 0 |
| 240 hr | 0 | 0 | 0 | 0 | 80 | 80 | 0 |
| 500 hr | 0 | 0 | 0 | 0 | 100 | 100 | 0 |
| 750 hr | 0 | 0 | 0 | 0 | | | 0 |
| 1,000 hr | 0 | 0 | 0 | 0 | | | 0 |
| n=20 (sample size) | | | | | | | |

Comparative example 3 is a composition that does not satisfy the refractive index condition of the present invention. Although the device formed using this composition exhibited favorable thermal shock resistance properties, its transparency was inferior.

The composition of the present invention is ideal for encapsulating semiconductors, and particularly optical semiconductors.

## Claims

1. A curable silicone rubber composition, comprising:

    (A) a linear organopolysiloxane (A-1) represented by a general formula (1) shown below, having a viscosity at 25°C within a range from 10 to 1,000,000 mPa·s,

    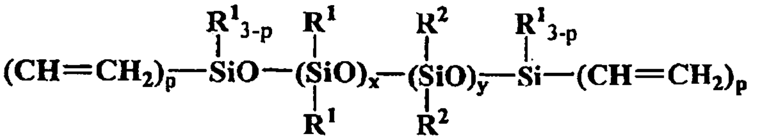
    (1)

    wherein each $R^1$ represents, independently, an unsubstituted or substituted monovalent hydrocarbon group, each $R^2$ represents, independently, an unsubstituted or substituted monovalent hydrocarbon group having no aliphatic unsaturated bonds, x and y each represents either 0 or a positive integer, provided that x+y is a number that yields a viscosity at 25°C for the organopolysiloxane of 10 to 1,000,000 mPa·s, and p is an integer from 1 to 3, or
    a mixture of the organopolysiloxane (A-1) and a resin-structure organopolysiloxane (A-2) composed of $SiO_2$ units, $R^3_kR^4_pSiO_{0.5}$ units and $R^3_qR^4_rSiO_{0.5}$ units, wherein $R^3$ represents a vinyl group or allyl group, $R^4$ represents a monovalent hydrocarbon group containing no aliphatic unsaturated bonds, k is 2 or 3 and p is 0 or 1, provided that k+p = 3, q is 0 or 1 and r is 2 or 3, provided that q+r = 3,
    (B) an organohydrogenpolysiloxane having two or more SiH groups within each molecule,
    (C) a metal-based condensation reaction catalyst,
    (D) a platinum group metal-based addition reaction catalyst, and
    (E) an organopolysiloxane-based adhesion-imparting agent containing at least two types of functional groups selected from the group consisting of alkenyl groups, alkoxy groups and epoxy group, wherein
    among refractive indices of component (A), a mixture of component (A) and component (B), and component (E), a difference between a maximum refractive index and a minimum refractive index is not more than 0.03.

2. The curable silicone rubber composition according to Claim 1, wherein
    $R^1$ is selected from the group consisting of:

    alkyl groups; aryl groups; aralkyl groups; alkenyl groups; and groups in which some or all of the hydrogen atoms within one of the above hydrocarbon groups have been replaced with a halogen atom or a cyano group;

    and wherein R2 and R4 are, independently, selected from the group consisting of:

    alkyl groups; aryl groups; aralkyl groups; and groups in which some or all of the hydrogen atoms within one of the above hydrocarbon groups have been replaced with a halogen atom or a cyano group.

3. The curable silicone rubber composition according to Claim 1 or 2, wherein
    among refractive indices of component (A), a mixture of component (A) and component (B), and component (E), a difference between a maximum refractive index and a minimum refractive index is not more than 0.02.

4. The curable silicone rubber composition according to Claim 1, 2 or 3, wherein component (A-2) is comprised within component (A) in an amount of from 20 to 70% by mass.

5. The curable silicone rubber composition according to any one of Claims 1 to 4, wherein component (A) and component

(E) both contain no aromatic groups.

6. The curable silicone rubber composition according to Claim 1, 2 or 3, wherein at least one of component (A), component (B) and component (E) contains aromatic groups, and, among aromatic group mol% values of the components, a maximum value and a minimum value satisfy a formula shown below:

$$[(\text{maximum value} - \text{minimum value}) / \text{maximum value}] \leq 0.3.$$

7. The curable silicone rubber composition according to any one of Claims 1 to 6, comprising
component (B) in an amount sufficient to provide an amount of SiH groups within component (B) of 0.7 to 4.0 mols per mol of alkenyl groups within component (A),
component (E) in an amount of 0.01 to 10 parts by mass per 100 parts by mass of component (A),
component (C) in an amount of 0.005 to 10 parts by mass per 100 parts by mass of a combination of component (A) and component (E), and
component (D) in an amount sufficient to provide an equivalent mass of platinum group metal of 0.1 to 1,000 ppm relative to a mass of component (A).

8. The curable silicone rubber composition according to any one of Claims 1 to 7, wherein component (C) is an aluminum-based catalyst or a zirconium-based catalyst.

9. A semiconductor device, comprising a semiconductor chip, and a cured product of a curable silicone rubber composition according to any one of Claims 1 to 8.

10. The curable silicone rubber composition according to Claim 8, wherein component (C) is a zirconium-based catalyst.

11. The curable silicone rubber composition according to Claim 10, wherein component (C) is a zirconium alkoxide.

## Patentansprüche

1. Härtbare Silikonkautschukzusammensetzung, umfassend:

(A) ein lineares Organopolysiloxan (A-1), das durch die nachstehend gezeigte allgemeine Formel (I) wiedergegeben wird, mit einer Viskosität bei 25°C im Bereich von 10 bis 1.000.000 mPa·s,

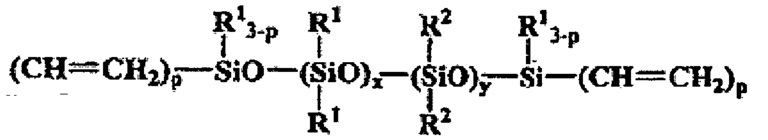

(1)

worin $R^1$ jeweils unabhängig voneinander für eine unsubstituierte oder substituierte einwertige Kohlenwasserstoffgruppe steht, $R^2$ jeweils unabhängig voneinander für eine unsubstituierte oder substituierte einwertige Kohlenwasserstoffgruppe ohne aliphatische ungesättigte Bindungen steht, x und y jeweils für 0 oder eine positive ganze Zahl stehen, mit der Maßgabe, dass x+y eine Zahl ist, die eine Viskosität bei 25°C für das Organopolysiloxan von 10 bis 1.000.000 mPa·s ergibt, und p für eine ganze Zahl von 1 bis 3 steht, oder
eine Mischung des Organopolysiloxans (A-1) und eines Harzstruktur aufweisenden Organopolysiloxans (A-2) aus $SiO_2$-Einheiten, $R^3_kR^4_pSiO_{0,5}$-Einheiten und $R^3_qR^4_rSiO_{0,5}$-Einheiten, wobei $R^3$ für eine Vinylgruppe oder Allylgruppe steht, $R^4$ für eine einwertige Kohlenwasserstoffgruppe ohne aliphatische ungesättigte Bindungen steht, k für 2 oder 3 steht und p für 0 oder 1 steht, mit der Maßgabe, dass k+p = 3, q für 0 oder 1 steht und r für 2 oder 3 steht, mit der Maßgabe, dass q+r = 3,
(B) ein Organohydrogenpolysiloxan mit zwei oder mehr SiH-Gruppen in jedem Molekül,
(C) einen Kondensationsreaktionskatalysator auf Metallbasis,
(D) einen Additionsreaktionskatalysator auf Platingruppenmetallbasis und
(E) einen auf Organosiloxan basierenden Haftvermittler, der mindestens zwei Typen von funktionellen Gruppen

aus der Gruppe bestehend aus Alkenylgruppen, Alkoxygruppen und Epoxidgruppen enthält, wobei unter den Brechungsindices von Komponente (A), einer Mischung von Komponente (A) und Komponente (B) und Komponente (E) eine Differenz zwischen einem maximalen Brechungsindex und einem minimalen Brechungsindex höchstens 0,03 beträgt.

**2.** Härtbare Silikonkautschukzusammensetzung nach Anspruch 1, wobei $R^1$ aus der Gruppe bestehend aus Alkylgruppen, Arylgruppen, Aralkylgruppen, Alkenylgruppen und Gruppen, in denen die Wasserstoffatome in einer der obigen Kohlenwasserstoffgruppen ganz oder zum Teil durch ein Halogenatom oder eine Cyanogruppe ersetzt sind, ausgewählt ist und wobei R2 und R4 unabhängig voneinander aus der Gruppe bestehend aus Alkylgruppen, Arylgruppen, Aralkylgruppen und Gruppen, in denen die Wasserstoffatome in einer der obigen Kohlenwasserstoffgruppen ganz oder zum Teil durch ein Halogenatom oder eine Cyanogruppe ersetzt sind, ausgewählt sind.

**3.** Härtbare Silikonkautschukzusammensetzung nach Anspruch 1 oder 2, wobei unter den Brechungsindices von Komponente (A), einer Mischung von Komponente (A) und Komponente (B) und Komponente (E) eine Differenz zwischen einem maximalen Brechungsindex und einem minimalen Brechungsindex höchstens 0,02 beträgt.

**4.** Härtbare Silikonkautschukzusammensetzung nach Anspruch 1, 2 oder 3, wobei Komponente (A-2) in Komponente (A) in einer Menge von 20 bis 70 Massen-% enthalten ist.

**5.** Härtbare Silikonkautschukzusammensetzung nach einem der Ansprüche 1 bis 4, wobei die Komponente

(A) und die Komponente (E) beide keine aromatischen Gruppen enthalten.

**6.** Härtbare Silikonkautschukzusammensetzung nach Anspruch 1, 2 oder 3, wobei Komponente (A), Komponente (B) und/oder Komponente (E) aromatische - Gruppen enthält und unter den Mol-%-Werten der aromatischen Gruppen der Komponenten ein Maximalwert und ein Minimalwert der nachstehend gezeigten Formel genügen:

$$[(\text{Maximalwert} - \text{Minimalwert})/\text{Maximalwert}] \leq 0{,}3.$$

**7.** Härtbare Silikonkautschukzusammensetzung nach einem der Ansprüche 1 bis 6, umfassend Komponente (B) in einer Menge, die zur Bereitstellung einer Menge von SiH-Gruppen in Komponente (B) von 0,7 bis 4,0 mol pro Mol Alkenylgruppen in Komponente (A) ausreicht, Komponente (E) in einer Menge von 0,01 bis 10 Massenteilen pro 100 Massenteile Komponente (A), Komponente (C) in einer Menge von 0,005 bis 10 Massenteile pro 100 Massenteile einer Kombination von Komponente (A) und Komponente (E) und Komponente (D) in einer Menge, die zur Bereitstellung einer Äquivalentmasse von Platingruppenmetall von 0,1 bis 1000 ppm, bezogen auf eine Masse von Komponente (A), ausreicht.

**8.** Härtbare Silikonkautschukzusammensetzung nach einem der Ansprüche 1 bis 7, wobei es sich bei Komponente (C) um einen auf Aluminium basierenden Katalysator oder einen auf Zirconium basierenden Katalysator handelt.

**9.** Halbleitervorrichtung, umfassend einen Halbleiterchip und ein gehärtetes Produkt einer härtbaren Silikonkautschukzusammensetzung nach einem der Ansprüche 1 bis 8.

**10.** Härtbare Silikonkautschukzusammensetzung nach Anspruch 8, wobei es sich bei Komponente (C) um einen auf Zirconium basierenden Katalysator handelt.

**11.** Härtbare Silikonkautschukzusammensetzung nach Anspruch 10, wobei es sich bei Komponente (C) um ein Zirconiumalkoxid handelt.

## Revendications

**1.** Composition de caoutchouc silicone durcissable, comprenant :

(A) un organopolysiloxane linéaire (A-1) représenté par la formule générale (1) indiquée ci-dessous, présentant une viscosité à 25°C dans une fourchette de 10 à 1 000 000 mPa.s,

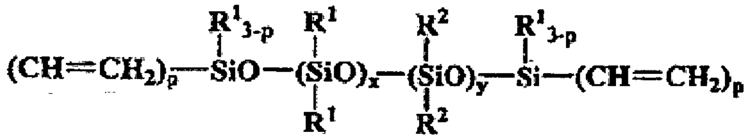

(1)

dans laquelle chaque radical $R^1$ représente, indépendamment, un groupe hydrocarboné monovalent non substitué ou substitué, chaque radical $R^2$ représente, indépendamment, un groupe hydrocarboné monovalent non substitué ou substitué ne contenant pas de liaisons insaturées aliphatiques, x et y représentent chacun 0 ou un nombre entier positif, du moment que x+y est un nombre qui conduit à une viscosité à 25°C pour l'organopolysiloxane de 10 à 1 000 000 mPa.s, et p est un nombre entier de 1 à 3, ou
un mélange de l'organopolysiloxane (A-1) et d'un organopolysiloxane ayant la structure d'une résine (A-2) composé de motifs $SiO_2$, de motifs $R^3{}_kR^4{}_pSiO_{0,5}$ et de motifs $R^3{}_qR^4{}_rSiO_{0,5}$, dans lesquels $R^3$ représente un groupe vinyle ou un groupe allyle, $R^4$ représente un groupe hydrocarboné monovalent ne contenant pas de liaisons insaturées aliphatiques, k est égal à 2 ou 3 et p est égal à 0 ou 1, du moment que k+p = 3, q est égal à 0 ou 1 et r est égal à 2 ou 3, du moment que q+r = 3,
(B) un organohydrogénopolysiloxane comportant deux ou plus de deux groupes SiH au sein de chaque molécule,
(C) un catalyseur de réaction de condensation à base de métal,
(D) un catalyseur de réaction d'addition à base de métal du groupe du platine, et
(E) un agent conférant de l'adhérence à base d'organopolysiloxane contenant au moins deux types de groupes fonctionnels choisis dans le groupe constitué par des groupes alcényle, des groupes alcoxy et un groupe époxy, dans laquelle
parmi les indices de réfraction du composant (A), d'un mélange du composant (A) et du composant (B), et du composant (E), la différence entre l'indice de réfraction maximum et l'indice de réfraction minimum ne dépasse pas 0,03.

**2.** Composition de caoutchouc silicone durcissable selon la revendication 1, dans laquelle $R^1$ est choisi dans le groupe constitué par :

les groupes alkyle ; les groupes aryle ; les groupes aralkyle ; les groupes alcényle ; et les groupes dans lequel une partie ou la totalité des atomes d'hydrogène présents dans un des groupes hydrocarbonés ci-dessus ont été remplacés par un atome d'halogène ou un groupe cyano ;

et dans laquelle $R^2$ et $R^4$ sont, indépendamment, choisis dans le groupe constitué par :

les groupes alkyle ; les groupes aryle; les groupes aralkyle ; et les groupes dans lequel une partie ou la totalité des atomes d'hydrogène présents dans un des groupes hydrocarbonés ci-dessus ont été remplacés par un atome d'halogène ou un groupe cyano.

**3.** Composition de caoutchouc silicone durcissable selon la revendication 1 ou 2, dans laquelle parmi les indices de réfraction du composant (A), d'un mélange du composant (A) et du composant (B), et du composant (E), la différence entre l'indice de réfraction maximum et l'indice de réfraction minimum ne dépasse pas 0,02.

**4.** Composition de caoutchouc silicone durcissable selon la revendication 1, 2 ou 3, dans laquelle le composant (A-2) est présent dans le composant (A) à raison de 20 à 70% en masse.

**5.** Composition de caoutchouc silicone durcissable selon l'une quelconque des revendications 1 à 4, dans laquelle le composant (A) et le composant (E) ne contiennent ni l'un ni l'autre de groupes aromatiques.

**6.** Composition de caoutchouc silicone durcissable selon la revendication 1, 2 ou 3, dans laquelle au moins un composant parmi le composant (A), le composant (B) et le composant (E) contient des groupes aromatiques, et, parmi les pourcentages molaires de groupes aromatiques des composants, le maximum et le minimum satisfont à la formule indiquée ci-dessous :

$$[(\text{maximum} - \text{minimum}) / \text{maximum}] \leq 0,3.$$

**7.** Composition de caoutchouc silicone durcissable selon l'une quelconque des revendications 1 à 6, comprenant
le composant (B) en quantité suffisante pour avoir une quantité de groupes SiH au sein du composant (B) de 0,7 à 4,0 moles par mole des groupes alcényle présents dans le composant (A),
le composant (E) en quantité de 0,01 à 10 parties en masse pour 100 parties en masse du composant (A),
le composant (C) en quantité de 0,005 à 10 parties en masse pour 100 parties en masse d'une combinaison du composant (A) et du composant (E), et
le composant (D) en quantité suffisante pour obtenir une masse équivalente de métal du groupe du platine de 0,1 à 1 000 ppm par rapport à la masse du composant (A).

**8.** Composition de caoutchouc silicone durcissable selon l'une quelconque des revendications 1 à 7, dans laquelle le composant (C) est un catalyseur à base d'aluminium ou un catalyseur à base de zirconium.

**9.** Dispositif à semi-conducteur, comprenant une puce à semi-conducteur, et un produit durci d'une composition de caoutchouc silicone durcissable selon l'une quelconque des revendications 1 à 8.

**10.** Composition de caoutchouc silicone durcissable selon la revendication 8, dans laquelle le composant (C) est un catalyseur à base de zirconium.

**11.** Composition de caoutchouc silicone durcissable selon la revendication 10, dans laquelle le composant (C) est un alcoolate de zirconium.

Fig. 1

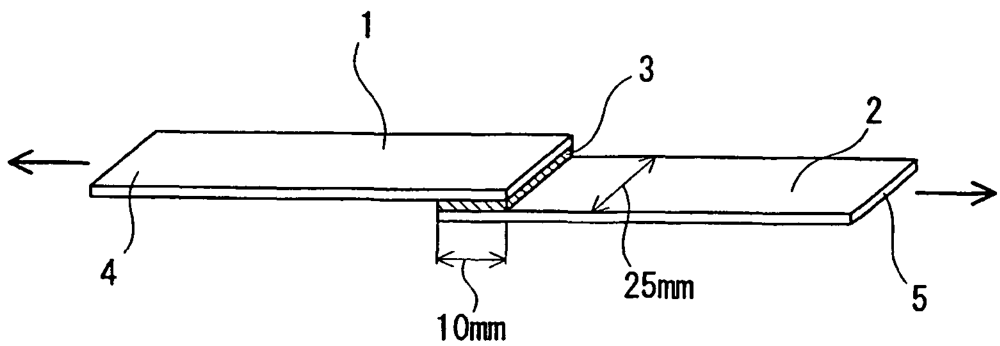


Fig. 2

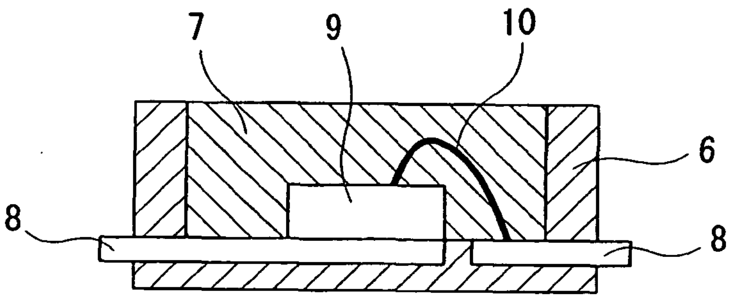

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003174059 A
- US 20060270792 A1